Europäisches Patentamt

European Patent Office

Office européen des brevets

(11) Publication number: **0 386 924**
**A2**

# EUROPEAN PATENT APPLICATION

(21) Application number: **90302089.9**

(22) Date of filing: **27.02.90**

(51) Int. Cl.5: **H05K  13/00**

(30) Priority: **05.03.89 IL 89488**

(43) Date of publication of application:
**12.09.90 Bulletin  90/37**

(84) Designated Contracting States:
**AT BE CH DE DK ES FR GB GR IT LI LU NL SE**

(71) Applicant: **ORBOT SYSTEMS Ltd.**
**New Industrial Area P.O. Box 215**
**IL-70650 Yavne(IL)**

(72) Inventor: **Peles, Netanel**
**36 Azar Street**
**Ramat Hasharon 47203(IL)**

(74) Representative: **Goodanew, Martin Eric et al**
**MATHISEN, MACARA & CO. The Coach**
**House 6-8 Swakeleys Road**
**Ickenham Uxbridge UB10 8BZ(GB)**

(54) A work station for orientation of a workpiece.

(57) A work station for orientation of a workpiece is described, the work station including a substantially plane mounting table (24) for the mounting thereon of a workpiece. The table (24) is adapted to perform a rotary movement about an axis perpendicular to its plane, and a translatory movement in a plane co-planar with its own plane. Drive means (28,30,32,34) effects the rotary and the translatory movement, an imaging axis parallel to the axis of rotation being located in the plane defined by the translatory movement performable by the axis of rotation as part of the table (24). Any location on the workpiece can be brought into alignment with the imaging axis by at least one of the movements.

Fig.4.

EP 0 386 924 A2

# A WORK STATION FOR ORIENTATION OF A WORKPIECE

The present invention relates to a work station for orientation of a workpiece relative to a fixed point, more particularly to a verification station for verifying the findings of automatic optical inspection systems concerning faults of printed-circuit boards.

Modern printed circuits (PC's) are highly complex and intricate networks of conductors, most of which vary in width between 0.05 and 0.4 mm, and their junctions and terminals. These networks must be inspected and, if need be, rectified, before lamination and the mounting of components, after which, testing for, e.g., continuity, absence of short-circuits, etc., is no longer an economically feasible proposition and, in case of multi-layer boards, altogether impossible.

Because of the complexity of the inspection task, use is made today of computerized automatic optical inspection (AOI) machines which, employing sophisticated pattern-recognition techniques, scan the PC-boards and are able to relatively rapidly discover such faults as breaks, short-circuiting bridges, unduly narrow points along a conductor or indeed total absence of a conductor where such a conductor is supposed to be, etc. The exact locations of whatever faults are detected are defined according to a Cartesian coordinate system. The xy-coordinates are acquirable either directly from the computer memory, or as printouts, or as ink marks on the inspected panel.

For two reasons, however, this type of automatic inspection was found to be insufficient: With all their sophistication, the AOI sys tems turned out to be fallible. Thus, a stretch of oxidized conductor (because of its reduced reflectivity) is liable to be interpreted as a break in, or total absence of, a conductor, and a dust speck is sometimes reported as impermissible narrowing of a conductor, or as short-circuiting matter. The second reason was the lack, on the AOI systems of the possibility to carry out repair work on the spot, such as using ribbon bonding to close a break, or a needle point to scratch away a short-circuiting metal blotch.

A verification of the findings of the AOI systems was therefore found necessary. This was carried out on so-called verification and rework stations (VRS's) which, basically, provided a relative xy-translatory movement between the PC-board and the optical axis of, say, a video camera or direct viewer. The xy-coordinates of the faults detected by the AOI system were fed to the translatory mechanism and, one by one, the faults reported were brought under the video-camera or the viewer that produced a magnified image of each fault location.

These verification stations, however, had a large "footprint", i.e., required much floor space as, with xy-movement of the table, the net area required for checking a square PC-board with a side length L is $2L \times 2L = 4L^2$. The actual size of such a station is obviously still larger. Taking into account the fact that a producer of PC's needs a relatively larger number of such stations to cope with his daily output of PC's, the disadvantages of the prior-art stations are obvious. Further drawbacks reside in the relatively long travel path, and thus, travel time involved in reaching peripheral points on the board, and the difficulties. for the operator, in reaching such points for purpose of on-the spot-sorting and repair of faults.

It is one of the objects of the present invention to overcome the disadvantages and drawbacks associated with prior-art verification stations, and to provide a station that takes up about 25% less floor space (net area required = $L\sqrt{2} \times (3L\sqrt{2}) = 3L^2$), works faster because of reduced travel-path lengths and provides safe and convenient operator access to any fault location on the board.

According to the invention, this is achieved by providing a work station for orientation of a workpiece, comprising a substantially plane mounting table for the mounting thereon of a workpiece, said table being adapted to perform a rotary movement about an axis perpendicular to its plane, and a translatory movement in a plane co-planar with its own plane, drive means for effecting said rotary and said translatory movement, and an imaging axis parallel to said axis of rotation and located in the plane defined by the translatory movement performable by said axis of rotation as part of said table, wherein, by at least one of said two movements, any location on said workpiece can be brought into alignment with said imaging axis.

It will be appreciated that the advantages of the present invention are based on a design facilitating the transformation of the Cartesian xy-fault location data supplied by an AOI system into polar, rθdata to be used by the VRS according to the invention.

The invention will now be described in connection with certain preferred embodiments with reference to the following illustrative figures so that it may be more fully understood.

With specific reference now to the figures in detail, it is stressed that the particulars shown are by way of example and for purposes of illustrative discussion of the preferred embodiments of the present invention only and are presented in the cause of providing what is believed to be the most useful and readily understood description of the principles and conceptual aspects of the invention.

In this regard, no attempt is made to show structural details of the invention in more detail than is necessary for a fundamental understanding of the invention, the description taken with the drawings making apparent to those skilled in the art how the several forms of the invention may be embodied in practice.

In the drawings:

Fig. 1 represents a frontal view of the work station according to the invention;

Fig. 2 is a top view of the station of Fig. 1;

Fig. 3 is a lateral view of the station of Fig. 1 as seen in direction of arrow A;

Fig. 4 is a perspective view revealing some inside components of the work station, and

Figs. 5 to 7 are schematic representations, showing the mounting table and a PC-board mounted thereon in various stages of angular and translatory displacement.

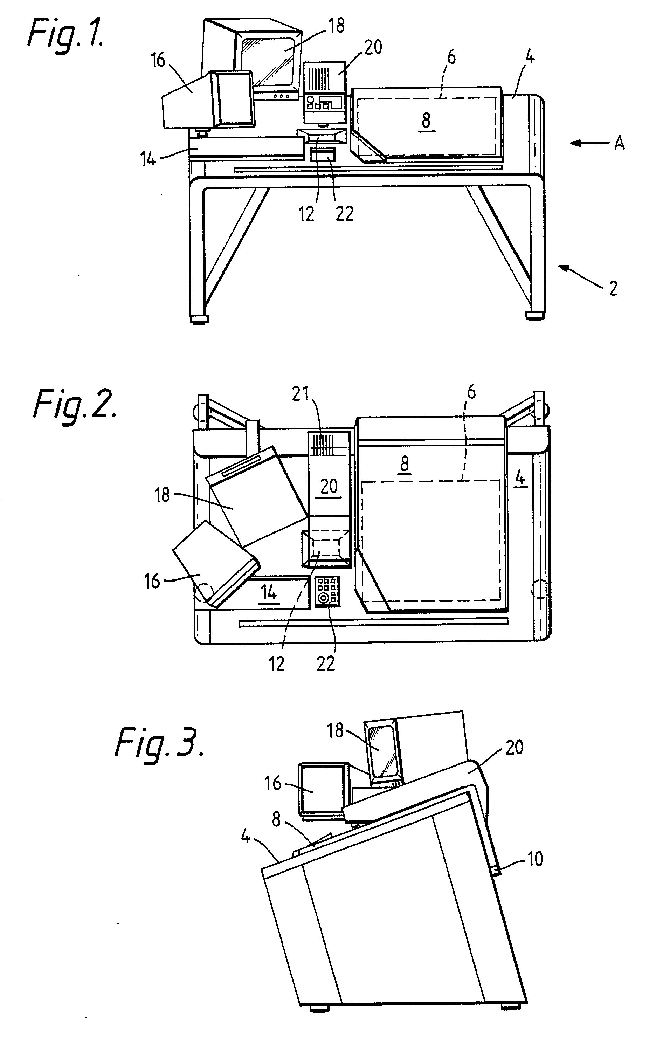

Referring now to the drawings, there is seen in Figs. 1 to 3 an application of the work station according to the invention used as a verification and repair station and comprising a desk-like structure (in the following, "desk") 2 with an inclined top 4 provided with a relatively large, window-like opening 6 (dashed outlines) coverable by a safety cover 8 which, for loading and unloading of the PC-boards to be verified, can be tilted open about a hinge 10 attached to the desk. A smaller opening 12, having bevelled edges, is located adjacent to the large opening 6 and serves a purpose to be discussed further below.

On the desk top 4 are mounted a computer keyboard 14 and display screen 16, as well as a video monitor 18.

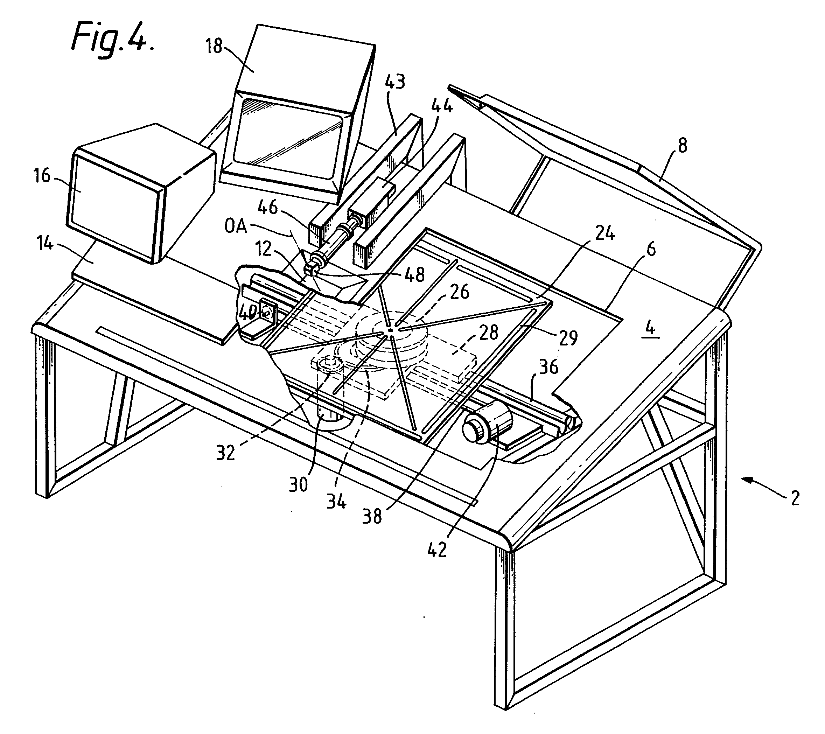

Also seen attached to the desk 2 is a housing 20 which accommodates a video camera and an optical system shown in Fig. 4 and described in greater detail in conjunction with that figure, as well as a light source to provide the illumination required for the video camera.

Further mounted on the desk top 4 is a control panel 22 comprising a joystick and several pushbuttons and LEDs, the purpose of which will be explained further below.

Referring now to Fig. 4 which shows the desk 2 with the cover 8 tilted up, there is seen a substantially square PC-board-mounting table 24 attached to a hub 26 and rotatably mounted on a carriage 28. The table 24, located in a plane substantially parallel with the inclined desk top 4, is provided with a number of T-slots 29 into which can be inserted, and tightened fast, locating pins smoothly fitting pre-drilled holes in the PC-boards, which pins, once set for a first board of a series and locked, would then ensure uniformity of location for the entire series, relative to table coordinates.

While the pins determine the location of a PC-board relative to the table 24, they do not ensure its flatness, i.e., its being pressed against the table. This is effected, locally only, in the region of the access window 12 by a kind of "presser foot" (not shown) in the shape of an approximately horseshoe-shaped, brush-like array of bristles mounted on a metal backing surrounding the access opening 12 on three sides and adapted to be lifted and lowered hydraulically. When lowered, the bristles push the board against the table 24 in the region of the opening 12 only. The two parallel wings of the horseshoe-shaped backing are provided with a series of small light sources opposite a series of photodetectors, producing a set of light barriers covering the area of the opening 12 and preventing or stopping any movement of the table 24 as long as any of the barriers is interrupted by the hand or fingers of an operator, or by a tool wielded by the latter.

The table 24 is rotated by an electric motor 30 via a gear train comprising a pinion 32 on the motor shaft and an intermediate gear 34 mounted on the carriage 28 and engaging a gear wheel (not shown) fixedly attached to the table hub 26. The motor 30 is also provided with encoder means for sensing the angular position of the motor shaft and, thus, of the table 24. The maximum angle of rotation required is ± 180°.

The carriage 28 which allows the table 24 to perform a translatory movement, is mounted on, and guided by, two guide rails 36, only one of which is shown. The carriage 28 is moved by a belt transmission 38, advantageously a timing belt extending between a deflection pulley 40 on the left and an electric motor 42 on the right. The latter, too, is provided with encoder means that sense the position of the carriage 28 along the guide rails 36.

The housing 20 (Figs. 1-3) having been removed, there are now seen two supporting arms 43 between which is mounted a video camera 44 comprising a motorized zoom lens 46 for pushbutton control of image magnification, and a deflection prism 48 which deflects the light, reflected from the PC-board portion below the access window 12, into the video camera via the zoom lens 46.

A light source (not shown) is accommodated in the housing 20 below the ventilation slots 21 (Fig. 2). Light from this source is brought forward and directed through the access window 12 onto the PC-board checked, by a bundle of optical fibers (not shown).

The optical axis OA of the deflection prism 48 (which is obviously the terminal portion of the optical axis of the camera 44, including the zoom lens 46) passes through the center of the access opening 12. it is parallel to the axis of rotation of the table 24 and located in the plane defined by the translatory movement performable by that axis as part of the table 24 on its carriage 28.

Angularly and translatorily, the table 24 has a "home" or "zero" position sensed by the respective encoders and, thus, accurately reproducible.

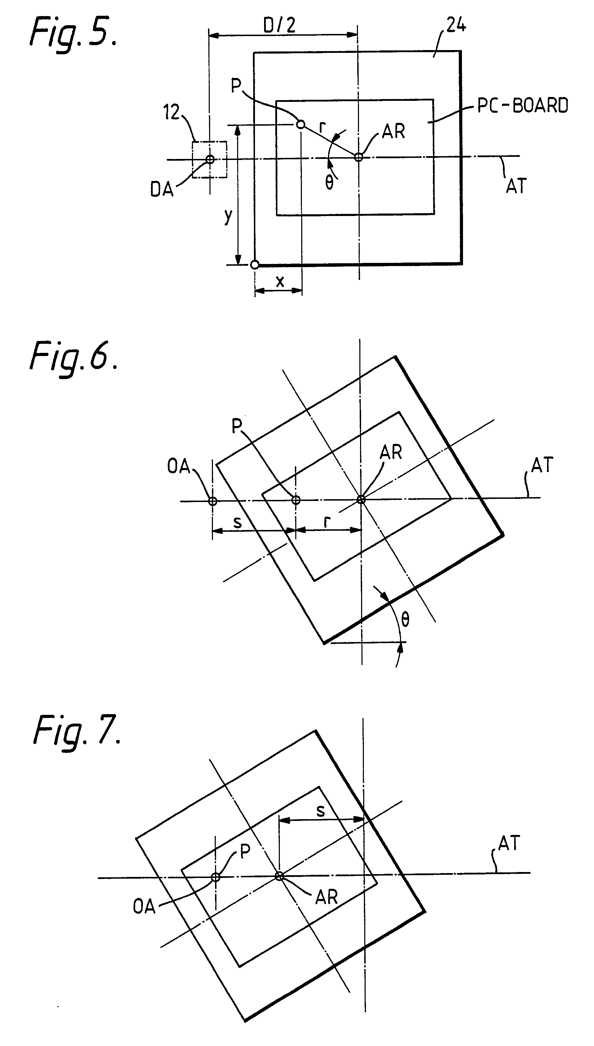

The angular "home" position corresponds to the position in which two sides of the square table 24 are parallel to the guide rails 36, and in which a point O (see Fig. 5) serving as origin of a Cartesian system of coordinates defining the positions of all points on the table, is at the lower left corner of the table.

Translatorily, the "home" position of the table 24 corresponds to the extreme right position along the guide rails 36, when, in the angular home position, the table is fully below the loading and unloading opening 6. In this position, the distance between the axis of rotation AR and the optical axis OA is, in principle, $D/2$, D being the diagonal of the square table 24 (see Fig. 5). In actual fact, this distance is larger by a few millimeters.

It will be remembered that the task of the verification system is to allow the operator to carefully scrutinize the fault locations established by an AOI system and to permit the operator to rectify such faults on the spot if at all possible, or at least to clearly mark such locations for repair at a subsequent stage.

It will be further remembered that, according to the invention, this is effected by transforming the Cartesian coordinates of the respective fault locations, as supplied by the AOI system, into polar coordinates used to determine the table movements of the VS.

Figs. 5-7 illustrate the realization of this principle in three stages. It should be stressed that the first stage (Fig. 5) (the mathematical transformation of $P(x,y)$ into $P(r,\theta)$ consists of a real-time computer operation, and the second and third stage (Figs. 6,7) are based upon the above transformation and illustrate the angular and translatory movements of the table 24 which, in fact, take place simultaneously, having been separated here only for didactic reasons.

Seen in Fig. 5 is the table 24 with its axis of rotation AR and axis of translation AT. Also seen in the above-mentioned imaginary point of origin of a Cartesian system of coordinates and the imaging or optical axis OA located (within the access opening 12) on the axis of translation AT at a distance $D/2$ from the axis of rotation AR of the table 24 assumed to be in its "home" position, with D denoting the diagonal of the square table 24.

Mounted on table 24 is a PC-board on which the preceding inspection on an AOIM has established a fault at point P having, relative to the origin O, the rectangular coordinates x,y. (These coordinates are computer-performed orthogonal transformations of the xy-coordinates of the fault point P as determined on the AOIM).

These xy-coordinates of P, with O as origin, are now transformed into $r\theta$-coordinates with AR as origin or pole. As is clearly seen in Fig. 5, for point P to eventually reach the optical axis OA, it must be swung into the axis of translation AT, which requires a rotation or swivel by $\theta°$, in the counterclockwise sense. While the same effect could also be obtained by a swivel in the clockwise sense, the whole operation would take longer, not only because the required angle of rotation would be larger ($180-\theta$, instead of merely $\theta$) but also because the subsequent translatory movement required would be longer ($(D/2) + r$, instead of $(D/2)-r$).

In Fig. 6 this swivel by $\theta°$ has been carried out, and point P is now located on the axis of translation AT. It is seen that the translatory path required to bring P into the optical axis OA is $s = (D/2)-r$, r being the radius vector of the system of polar coordinates.

In Fig. 7, translation along AT has been completed and fault point P has been moved into the optical axis. It can now be displayed with variable magnification on the monitor screen 18. Observing his actions on the monitor 18, the operator can now undertake whatever repair work may be necessary.

The computer, represented in the drawings by the keyboard 14 and the display screen 16 contains the program and memory, and controls the overall functioning of the verification system. It can be addressed by the "menu" mode.

The actual functions of the verification station are controlled by the operator with the aid of the control panel 22 (Fig. 2) having a number of pushbuttons and a joystick. These functions include:
Focusing ±
Zooming ±
Light intensity ±
Calling next fault
Recalling previous fault
Centering fault location on screen
Marking of fault location on board
"Presser foot" up-down
Enabling joystick
The joystick permits manual control of all table movements.

The verification station can also be used to measure distances between points on the board, e.g., the width of conductors, or the width of narrowing faults, and the like.

An optional piece of equipment would be a binocular microscope (including, possibly, a micromanipulator) for repair work on PC-boards produced by advanced technologies.

It will be evident to those skilled in the art that the invention is not limited to the details of the foregoing illustrative embodiments and that the present invention may be embodied in other specific forms without departing from the spirit or essential attributes thereof. The present embodiments are therefore to be considered in all respects as illustrative and not restrictive, the scope of the invention being indicated by the appended claims rather than by the foregoing description, and all changes which come within the meaning and range of equivalency of the claims are therefore intended to be embraced therein.

## Claims

1. A work station for orientation of a workpiece, comprising:
a substantially plane mounting cable (24) for the mounting thereon of a workpiece, said table being adapted to perform a rotary movement about an axis perpendicular to its plane, and a translatory movement in a plane co-planar with its own plane;
drive means (28,30,32,34,36,38,40,42) for effecting said rotary and said translatory movement, and
an imaging axis parallel to said axis of rotation and located in the plane defined by the translatory movement performable by said axis of rotation as part of said table (24),
wherein, by at least one of said two movements, any location on said workpiece can be brought into alignment with said imaging axis.

2. The work station as claimed in claim 1, wherein said imaging axis constitutes at least a portion of an imaging means.

3. The work station as claimed in claim 2, wherein said imaging means is a video camera (44).

4. The work station as claimed in claim 3, wherein said video camera (44) is provided with a motor-driven zoom lens (46) to provide variable magnification, and with a display screen (18).

5. The work station as claimed in any one of the preceding claims, further comprising computer means for transforming input data consisting of Cartesian coordinates into output data consisting of polar coordinates $(r,\theta)$ and for controlling said rotary and said translatory motion.

6. The work station as claimed in claim 5, further comprising a keyboard (14) and a display screen (16) for said computer means.

7. The work station as claimed in any one of the preceding claims, wherein said mounting table (24) is substantially square.

8. The work station as claimed in any one of the preceding claims, wherein said mounting table (24) is provided with a plurality of T-slots (29) for the fixing therein of locating pins.

9. The work station as claimed in any one of the preceding claims, wherein said drive means are electric motors (30,42) provided with angular encoders.

Fig.1.

Fig.2.

Fig.3.

*Fig.4.*

EP 0 386 924 A2

**Fig. 5.**

**Fig. 6.**

**Fig. 7.**